# EUROPEAN PATENT SPECIFICATION

(11) **EP 3 663 157 B1**
(45) Date of publication and mention of the grant of the patent: **28.12.2022**
(21) Application number: 18840294.5
(22) Date of filing: 25.05.2018
(51) Int. Cl.: B61C 17/00, B61C 17/12, H02M 7/48, H05K 7/20

(54) **POWER CONVERSION DEVICE AND RAILROAD VEHICLE**
ENERGIEUMWANDLUNGSVORRICHTUNG UND SCHIENENFAHRZEUG
DISPOSITIF DE CONVERSION DE PUISSANCE ET VÉHICULE FERROVIAIRE

(30) Priority: 04.08.2017 JP 2017151673
(43) Date of publication of application: 10.06.2020
(73) Proprietor: Kabushiki Kaisha Toshiba, Minato-ku Tokyo 105-8001 (JP); Toshiba Infrastructure Systems & Solutions Corporation, Kawasaki-shi, Kanagawa 212-0013 (JP)
(72) Inventor: TSUKINARI, Yuuki, Tokyo 105-8001 (JP); FUJIWARA, Nobuto, Tokyo 105-8001 (JP); FUJITO, Haruhiko, Kawasaki-shi, Kanagawa 212-0013 (JP)
(74) Representative: AWA Sweden AB
(86) International application number: PCT/JP2018/020148
(87) International publication number: WO 2019/026400

(56) References cited:
- EP-A1- 2 412 597
- EP-A1- 2 789 518
- WO-A1-2010/109799
- WO-A1-2016/110977
- JP-A- H10 297 482
- JP-A- 2000 158 938
- JP-A- 2013 193 486
- JP-A- 2017 039 481
- JP-A- 2017 039 481
- US-A1- 2016 143 193

## Description

### FIELD

Embodiments described herein relate generally to a power conversion device and a railway vehicle.

### BACKGROUND

A railway vehicle is equipped with a power conversion device that converts electric power supplied from an overhead line into desired electric power and controls driving of a main motor or the like. This type of power conversion device includes a semiconductor element and a cooler for cooling the semiconductor element.

Such coolers are roughly classified into a forced circulating liquid cooling system using a pump or the like, a forced air cooling system using a fan or the like, and a traveling wind natural air cooling system using traveling wind. Recently, the traveling wind natural air cooling system has become the mainstream from the viewpoints of noise reduction, energy saving, and maintenance-free.

A cooler of this traveling wind natural air cooling system includes a heat receiving block and a plurality of fins (air receiver). A semiconductor element is mounted on the heat receiving block. Each fin is connected to the heat receiving block. The fins extend in parallel with each other along the longitudinal direction of the vehicle. Therefore, a flow passage through which the traveling wind flows during traveling of the railway vehicle is formed between the adjacent fins. When the traveling wind passes through the flow passage, heat is exchanged between the traveling wind and the fins. As a result, heat generated in the semiconductor element is dissipated through the fins.

Incidentally, in the conventional power conversion device described above, the pressure loss when the traveling wind passes through the flow passage is large. Therefore, there is a possibility that the traveling wind flowing into the flow passage from the front side in the assumed travel direction in the railway vehicle may flow out of the flow passage without reaching the rear end in the assumed travel direction in the flow passage. Especially, when the railway vehicle is traveling at a low speed, the force of the traveling wind is weak, and there is a possibility that the traveling wind does not reach the rear end in the assumed travel direction in the flow passage.

### CITATION LIST

PATENT LITERATURE 1:Jpn. Pat. Appln. KOKAI Publication No. 2013-103506

JP 2017-039481 A

JP 2000-158938 A

### SUMMARY

### TECHNICAL PROBLEM

It is an object of the present invention to provide a power conversion device and a railway vehicle capable of effectively supplying traveling wind to an air receiver and securing desired cooling performance.

### SOLUTION TO PROBLEM

A power conversion device according to an embodiment comprises a semiconductor element, an air receiver, an air guide, an airflow straightener, and a flange. The semiconductor element is capable of outputting electric power for driving the vehicle. The air receiver is connected to the semiconductor element. Assuming that the assumed travel direction of a vehicle is a first direction, the direction of gravity is a second direction, and the direction perpendicular to the first direction and the second direction is a third direction, the air guide is disposed to face the air receiver in the third direction, and includes two ends in the first direction. The end closer to the center of the air receiver is defined as a first end and the end on the opposite side from the first end is defined as a second end. The airflow straightener extends from the first end of the air guide along the first direction and away from the second end.
The flange extends from the second end of the air guide and away from the air receiver. The distance between the second end of the air guide and the airflow straightener in the second direction is equal to or greater than the distance between the first end of the air guide and the air receiver in the second direction.

### BRIEF DESCRIPTION OF THE DRAWINGS

FIG.1 is a schematic side view illustrating a railway vehicle according to an embodiment.
FIG. 2 is a perspective view showing a power conversion device according to a first embodiment.
FIG. 3 is a cross-sectional view taken along the III-III line of FIG. 2.
FIG. 4 is an exploded perspective view showing the power conversion device according to the first embodiment.
FIG. 5 is a plan view showing a cover according to the first embodiment.
FIG. 6 is a graph showing changes in thermal resistance of the cooler when a railway vehicle of the first embodiment travels at low speed, medium speed, and high speed.
FIG. 7 is an exploded perspective view showing a power conversion device according to a second embodiment.
FIG. 8 is a plan view showing a cover of the second embodiment.
FIG. 9 is a plan view showing a diffuser according to the second embodiment.

### DETAILED DESCRIPTION

Hereinafter, a power conversion device and a railway vehicle according to the embodiments will be described with reference to the accompanying drawings. In each of the drawings described below, the scale of each member is changed as needed to make each member recognizable.

### (First Embodiment)

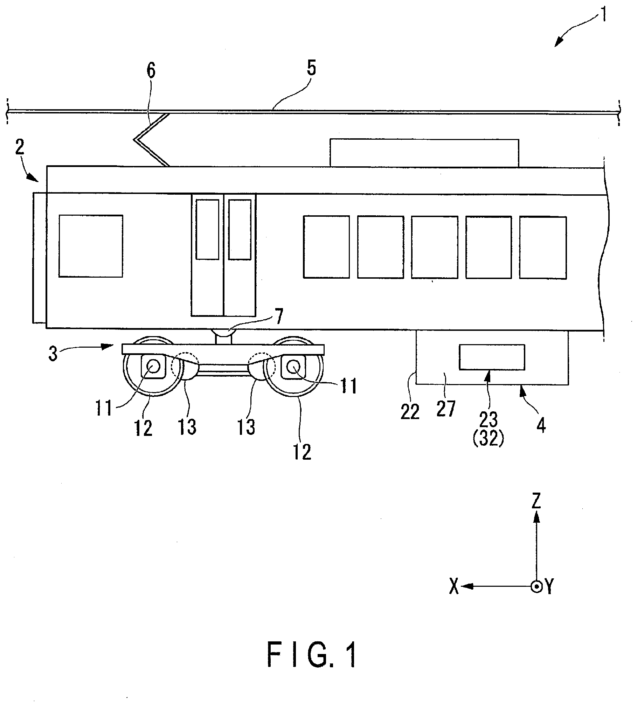

FIG. 1 is a schematic side view of a railway vehicle 1.

As shown in the figure, the railway vehicle 1 of the present embodiment includes a vehicle body 2, a cart 3 provided under the floor of the vehicle body 2, and a power conversion device 4 provided under the floor of the vehicle body 2 and configured to convert electric power supplied from the outside. In the following explanation, the quadrature coordinate system of X, Y, and Z will be used as necessary. In the present embodiment, the X direction coincides with the vehicle longitudinal direction (assumed travel direction) of the railway vehicle 1, the Y direction coincides with the vehicle width direction of the railway vehicle 1, and the Z direction coincides with the vertical direction.

The vehicle body 2 is formed in a rectangular parallelepiped shape long in the X direction. A space in which passengers can be accommodated is formed inside the vehicle body 2. A pantograph 6 protrudes from the ceiling of the vehicle body 2 in the +Z (upper) direction. The pantograph 6 is configured to be contactable with the overhead line 5.

The cart 3 is, for example, mounted under the floor of the vehicle body 2 via a cart spring 7 such as an air spring. A pair of axles 11 extending in the Y direction are rotatably supported at respective ends of the cart 3 in the X direction. Wheels 12 are attached to respective ends of the axle 11 in the Y direction. A main motor 13 for rotating each axle 11 is mounted on the cart 3. The cart 3 is attached to both ends of each vehicle body 2 in the X direction.

The power conversion device 4 is mounted on a portion located between the pair of carts 3 under the floor of the vehicle body 2.

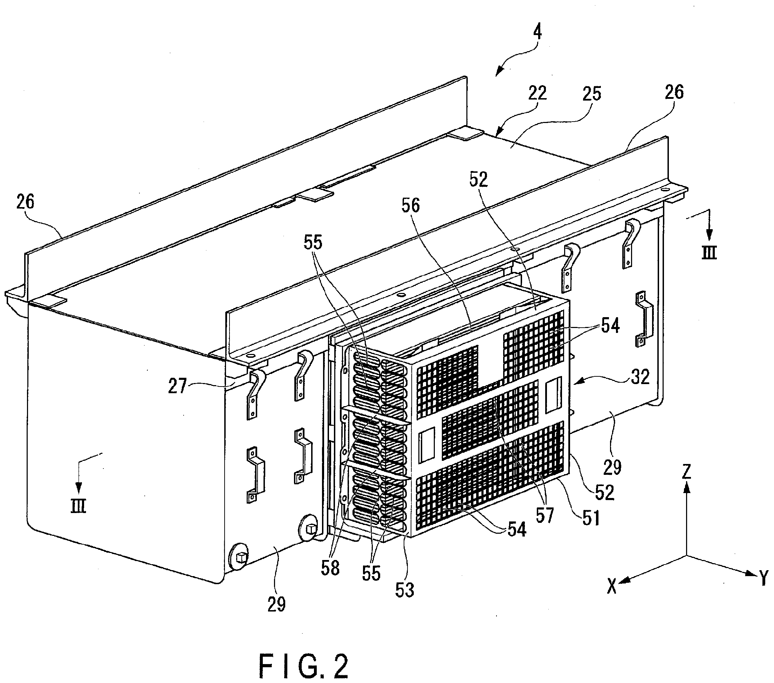

FIG. 2 is a perspective view of the power conversion device 4.

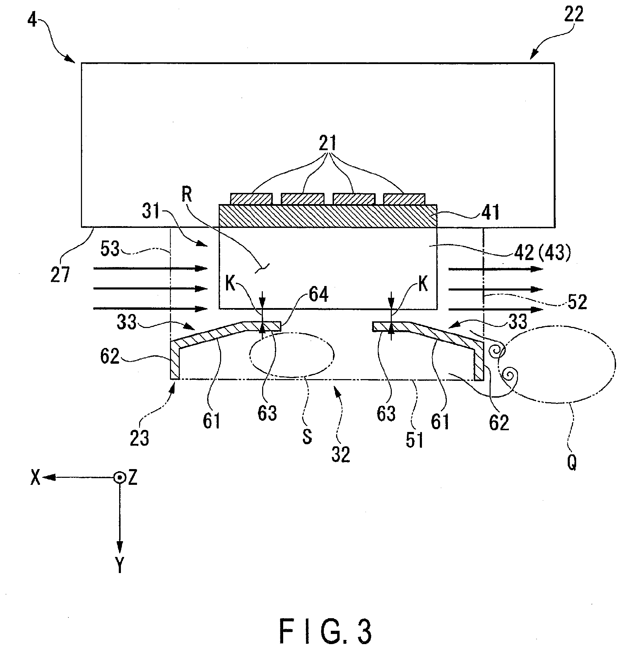

As shown in this figure, the power conversion device 4 includes a semiconductor element 21 (see FIG. 3), a housing 22 for housing the semiconductor element 21, and a cooler 23 for cooling the semiconductor element 21. In some cases of the following description, the direction approaching the central portion of the railway vehicle 1 in the Y direction is referred to as the inside in the Y direction, and the direction separating from the central portion of the railway vehicle 1 is referred to as the outside in the Y direction.

The housing 22 is formed in a rectangular parallelepiped shape long in the X direction. The housing 22 has a ceiling wall 25 at a portion positioned in the +Z direction. The ceiling wall 25 is provided with a mounting piece 26 protruding in the +Z direction. The mounting pieces 26 are provided at respective ends of the ceiling wall 25 in the Y direction. The power conversion device 4 is connected under the floor of the vehicle body 2 via the mounting pieces 26.

In addition, the housing 22 has a side wall 27 at a portion located outside in the Y direction. The side wall 27 is located more on the inner side in the Y direction than the side surface of the vehicle body 2 located on the outer side in the Y direction. Inspection doors 29 are provided at respective ends of the side wall 27 in the X direction. The inspection door 29 opens and closes an inspection window (not shown) formed in the side wall 27.

FIG. 3 is a cross-sectional view taken along the III-III line of FIG. 2.

As shown in the figure, the semiconductor element 21 is configured to be capable of outputting electric power for driving the railway vehicle 1. Specifically, the semiconductor element 21 receives DC power via the overhead line 5 and the pantograph 6, converts the DC power into AC power, and supplies the AC power to the main motor 13 and the like. The semiconductor element 21 constitutes a power conversion unit together with a control unit (not shown) and the like. The power conversion unit is collectively accommodated in the above-described housing 22. The control unit transmits and receives switching signals with the semiconductor element 21.

The cooler 23 includes a heat sink 31 for radiating heat generated in the semiconductor element 21, a cover 32 for covering the heat sink 31, and a diffuser 33 provided on an inner surface of the cover 32 in the Y direction.

The heat sink 31 is made of a material having a high thermal conductivity such as aluminum. The heat sink 31 is provided to penetrate the side wall 27 of the housing 22 in the Y direction in a state in which a part thereof protrudes outward in the Y direction from the side wall 27. The heat sink 31 includes a heat receiving block 41 and an air receiver 42.

The heat receiving block 41 protrudes inward in the Y direction with respect to the side wall 27. That is, the heat receiving block 41 is located inside the housing 22.

The above-described semiconductor element 21 is mounted on the inner end surface of the heat receiving block 41 in the Y direction. In the first embodiment, four semiconductor elements 21 are mounted at intervals in the X direction on the inner end surface of the heat receiving block 41 in the Y direction.

The air receiver 42 protrudes outward in the Y direction with respect to the side wall 27. That is, the air receiver 42 is located outside the housing 22. The air receiver 42 receives the traveling wind flowing mainly in the X direction as the railway vehicle 1 travels. The air receiver 42 includes a plurality of fins 43. The fin 43 is formed in a thin plate shape of which the thickness direction is the Z direction. The fins 43 project outward in the Y direction from the outer end surface of the heat receiving block 41 in the Y direction. The fins 43 are arranged on the outer end surface of the heat receiving block 41 in the Y direction at intervals in the Z direction. The fins 43 extend parallel to each other along the X direction. A ventilation path R for the travelling wind is formed between the fins 43 adjacent to each other in the Z direction. The ventilation paths R are opened on both sides in the X direction and toward the outside in the Y direction.

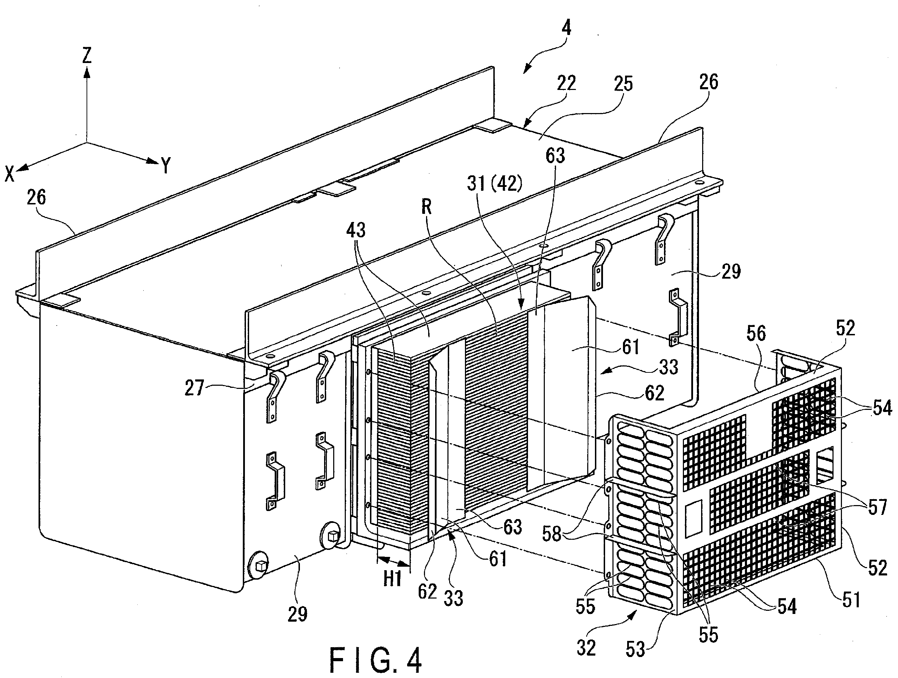

FIG. 4 is an exploded perspective view of the power conversion device 4.

As shown in the drawing, the cover 32 covers the air receiver 42 from both sides in the X direction and the Z direction, and from the outside in the Y direction. Specifically, the cover 32 has a top wall 51 disposed on the outer side in the Y direction with respect to the air receiver 42, a pair of lateral sidewalls 52 extending inward in the Y direction from sections of the outer peripheral edge of the top wall 51 located on both sides in the Z direction, and a pair of vertical sidewalls 53 extending inward in the Y direction from sections of the outer peripheral edge of the top wall 51 located on both sides in the X direction. The pair of lateral side walls 52 are opposed to each other in the Z direction. The pair of vertical side walls 53 are opposed to each other in the X direction. The inner ends in the Y direction of the lateral wall 52 and the vertical wall 53 are connected to the side wall 27 of the housing 22.

The top wall 51 is formed with a plurality of communication holes 54 for communication between the inside and the outside of the top wall 51. Each of the communication holes 54 is formed to have a substantially rectangular opening shape. The top wall 51 is provided with two stays 57 extending between both ends in the X direction. Further, the two stays 57 are arranged in the Z direction at the central area of the top wall 51 in the Z direction. The stay 57 is for reinforcing the top wall 51 in which the communication holes 54 are formed.

A plurality of communication holes 55 are formed in the pair of vertical side walls 53 for communication between the inside and the outside of the vertical side wall 53. Each of the communication holes 55 is formed in a substantially oval shape having an opening shape long in the Y direction. The vertical side wall 53 is provided with two stays 58 extending between both ends in the Y direction. Further, the two stays 58 are arranged side by side in the Z direction at locations corresponding to the two stays 57 provided on the top wall 51. The stay 58 is for reinforcing the vertical side wall 53 in which the communication holes 55 are formed.

An opening 56 is formed in most of the lateral side wall 52. The opening 56 also functions as a communication hole for communication between the inside and the outside of the lateral wall 52.

The cover 32 as such has a function of protecting the heat sink 31 (the air receiver 42) from foreign matter scattered during traveling, and circulating the traveling wind inside and outside the cover 32 through the communication holes 54 and 55 and the opening 56. In particular, of the communication holes 54 and 55, each communication hole 55 formed in the vertical side wall 53 has a substantially oval shape constituting a large opening area, so that as much traveling wind can be taken into the cover 32 as possible. In the cover 32, the communication holes 54 and 55 and the opening 56 are not formed at least in ridgeline sections between the walls 51, 52, and 53. If the strength of the air receiver 42 can be sufficiently secured, the cover 32 may not be provided.

As shown in FIG. 3, the diffusers 33 are provided on the inner surface of the cover 32 in the Y direction, and one diffuser 33 is disposed on each side in the X direction. In addition, each diffuser 33 is disposed outside in the Y direction (second direction) with respect to the air receiver 42, and faces the air receiver 42.

Each diffuser 33 is connected to the vertical side wall 53 of the cover 32.

The diffusers 33 are symmetrical to each other with respect to a symmetry plane (not shown) that agrees with the YZ plane extending through the center section in the X direction of the air receiver 42. Therefore, when it is not necessary to distinguish between the diffusers 33, the same reference numerals are given and redundant explanation is omitted. In the following description, the direction approaching the central section of the air receiver 42 in the X direction is referred to as the inside in the X direction, and the direction separating from the central section of the air receiver 42 is referred to as the outside in the X direction in some cases.

Each diffuser 33 is formed by integrally molding an air guide 61 occupying most of the center in the X direction, a flange 62 disposed at the outer end of the air guide 61 in the X direction, and an airflow straightener 63 disposed at the inner end of the air guide 61 in the X direction.

The air guide 61 is formed in a plate shape extending along the X direction. Specifically, the air guide 61 is inclined toward the outside in the Y direction from the inside to the outside in the X direction. That is, in the air guide 61, the distance between the air guide 61 and the air receiver 42 in the Y direction gradually increases from the inner end to the outer end in the X direction.

In a side view seen from the outside in the Y direction, the inner end of the air guide 61 in the X direction overlaps with the outer end of the air receiver 42 in the X direction. In a side view seen from the outside in the Y direction, the outer end of the air guide 61 in the X direction protrudes outward in the X direction from the outer end of the air receiver 42 in the X direction. The air guide 61 is provided in the cover 32 over the entire area in the Z direction.

The flange 62 is formed in a plate shape extending along the Y direction. The flange 62 protrudes outward in the Y direction from the outer end in the X direction of the air guide 61. The flange 62 is connected to the outer end in the Y direction of the above-described vertical side wall 53.

The airflow straightener 63 is formed in a plate shape extending along the X direction. The airflow straightener 63 protrudes inward in the X direction from the inner end in the X direction of the air guide 61. Further, the airflow straightener 63 protrudes so that a predetermined gap K is formed between the outer surface of the air receiver 42 in the Y direction and the airflow straightener 63. Further, the length of the airflow straightener 63 in the X direction is set to a length that allows a sufficient opening 64 to be secured between the airflow straighteners 63 when the two diffusers 33 are arranged in plane symmetry in the X direction.

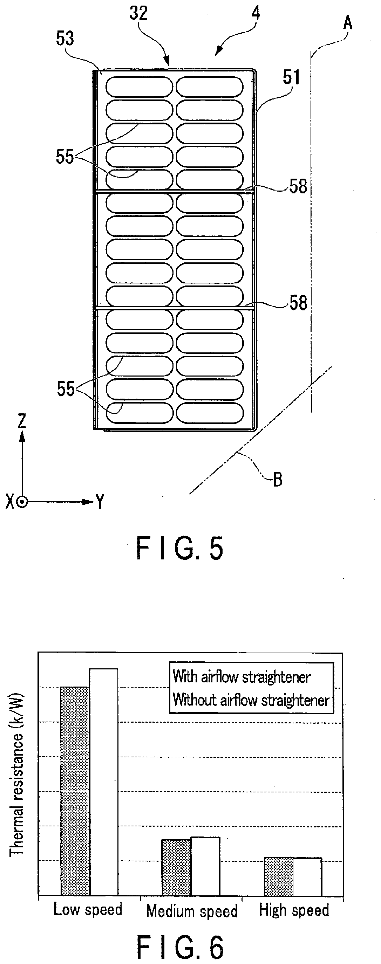

FIG. 5 is a plan view of the cover 32 as viewed from the X direction.

Here, under the floor of the vehicle body 2, there is an outfit limit as a space in which the cart 3 and the power conversion device 4 can be outfitted (see outfit limit lines A and B indicated by two-dot chain lines in FIG. 5). The power conversion device 4 is formed such that the cover 32 serving as the outermost package is accommodated inside (vehicle body 2 side) the outfit limit lines A and B.

Next, the operation of the railway vehicle 1 according to the first embodiment will be described. In the following description, a case where the railway vehicle 1 travels in the +X direction will be described. Therefore, in the following description, the front side (+X direction) in the assumed travel direction may be simply referred to as the front side, and the rear side (-X direction) in the assumed travel direction may be simply referred to as the rear side.

When the railway vehicle 1 is driven, AC power is first supplied from the semiconductor elements 21 to main motors 13, thereby rotating the main motors 13. Then, the rotational force of the main motor 13 is transmitted to the axle 11, whereby the axle 11 and the wheels 12 rotate. As a result, the railway vehicle 1 travels forward on a track (not shown). In the semiconductor element 21, heat is generated due to power loss at the time of power conversion. The heat generated in the semiconductor element 21 is transmitted to the fins 43 of the air receiver 42 via the heat receiving block 41.

On the other hand, when the railway vehicle 1 travels, the traveling wind mainly flows in the -X direction around the railway vehicle 1. That is, the traveling wind flows from the front side (upstream side) toward the rear side (downstream side) with respect to the railway vehicle 1.

As shown in FIG. 3, the traveling wind flows into the cover 32 through the communication holes 54 of the frontside vertical side wall 53 of the cover 32 (see an arrow in FIG. 3).

The traveling wind flowing into the cover 32 is guided by the air guide 61 of the diffuser 33 positioned on the front side and flows in the X direction. The traveling wind passes by the outer surface of the air receiver 42 and through the air passage R in the course of flowing in the X direction inside the cover 32. At this time, heat generated in the semiconductor element 21 is radiated through the air receiver 42 by the heat exchange between the air receiver 42 (fins 43) and the traveling wind. Thereafter, the traveling wind is discharged to the outside of the cover 32 through the communication holes 54 of the cover 32.

Here, when the traveling wind flowing through the cover 32 is discharged from the cover 32 through the communication holes 54 of the vertical side wall 53 located on the rear side, for example, the flow of the traveling wind is obstructed by the diffuser 33 (mainly the flange 62) on the rear side. Therefore, a vortex is formed in a region behind the rear diffuser 33. As a result, a low-pressure region Q having a lower pressure than the region forward of the rear diffuser 33 is formed in the region behind the rear diffuser 33.

Then, the traveling wind flowing through the cover 32 is drawn into the low-pressure region Q, so that the flow rate of the traveling wind passing through the inside (inside in the Y direction) of the rear diffuser 33 increases. As a result, the traveling wind that attempts to escape from the inside of the ventilation path R to the outside in the Y direction is pulled back into the ventilation path R, and the flow rate of the traveling wind that passes through the inside of the ventilation path R increases.

In this manner, the two diffusers 33 are arranged in the X direction so that the diffuser 33 positioned rearward with respect to the travel direction functions to increase the flow rate of the traveling wind. That is, when the railway vehicle 1 travels in the opposite direction (e.g., -X direction), the diffuser 33 located on the +X side functions.

Incidentally, when the railway vehicle 1 is traveling, the flow of the traveling wind is also obstructed by the diffuser 33 located on the front side in the travel direction, and a low-pressure area S is formed in the rear region of this front diffuser 33 (in other words, a region forward of the rear diffuser 33), where a pressure is lower than in the front region of the front diffuser 33. However, since the diffusers 33 are formed with the respective airflow straighteners 63 that extend toward each other (toward the X direction), the airflow straighteners 63 suppress the traveling wind from being drawn into the low-pressure region S. Therefore, the flow rate of the traveling wind passing through the inside (inside in the Y direction) of the rear diffuser 33 is further increased.

As described above, in the first embodiment, the diffuser 33 is configured to include the air guide 61, the flange 62, and the airflow straightener 63.

According to this configuration, the flow rate of the traveling wind passing through the rear diffuser 33 can be increased since the traveling wind flowing through the cover 32 is drawn toward the low-pressure region Q formed behind the rear diffuser 33. As a result, it is possible to draw back the traveling wind to escape from the air receiver 42 (the ventilation path R) into the ventilation path R.

Here, when the traveling wind volume is low, the differential pressure between the low-pressure region Q of the rear diffuser 33 and the periphery of the low-pressure region Q becomes small. For this reason, there is a possibility that the effect of increasing the traveling wind cannot be obtained. However, since the diffuser 33 is provided with the airflow straightener 63, it is possible to suppress the traveling wind from being drawn into the above-mentioned low-pressure region S. That is, even when the differential pressure between the low-pressure region Q of the rear diffuser 33 and the periphery of the low-pressure region Q is small, it is possible to suppress as much as possible the outflow amount of the traveling wind that attempts to escape from the inside of the ventilation path R to the outside in the Y direction. In particular, when the railway vehicle 1 travels at low speed, the differential pressure between the low-pressure region Q of the rear diffuser 33 and the periphery of the low-pressure region Q is small. However, it is possible to suppress as much as possible the outflow amount of the traveling wind that attempts to escape from the inside of the ventilation path R to the outside in the Y direction by the airflow straightener 63 of the diffuser 33.

FIG. 6 is a graph showing changes in the thermal resistance [k/W] of the cooler 23 when the railway vehicle 1 travels at low speed, medium speed, and high speed. In FIG. 6, the case where the airflow straightener 63 is provided (with an airflow straightener) is compared with the case where the airflow straightener 63 is not provided (without an airflow straightener).

As shown in the figure, it can be confirmed that the thermal resistance of the cooler 23 in the case where the airflow straightener 63 is provided is reduced as compared with the case where the airflow straightener 63 is not provided, particularly when the railway vehicle 1 is traveling at low speed. As such, it is possible to exert an effect of increasing the flow rate of the traveling wind in the air receiver 42 over the entire speed range of the railway vehicle 1. Therefore, the cooling performance of the air receiver 42 can be improved.

Further, the air guide 61 is inclined toward the outside in the Y direction from the inside to the outside in the X direction. Therefore, the low-pressure region Q is also formed in the rear diffuser 33. As a result, the flow rate of the traveling wind passing through the rear diffuser 33 can be further increased.

Further, diffusers 33 are disposed on respective sides of the air receiver 42 in the X direction. For this reason, in the case where the vehicle can travel toward both sides in the X direction as in the case of the railway vehicle 1, the above-described effects can be achieved without being limited by the assumed travel direction.

Consequently, with the power conversion device 4 having excellent cooling performance as described above, it is possible to provide the railway vehicle 1 having excellent reliability over a long period of time.

### (Second Embodiment)

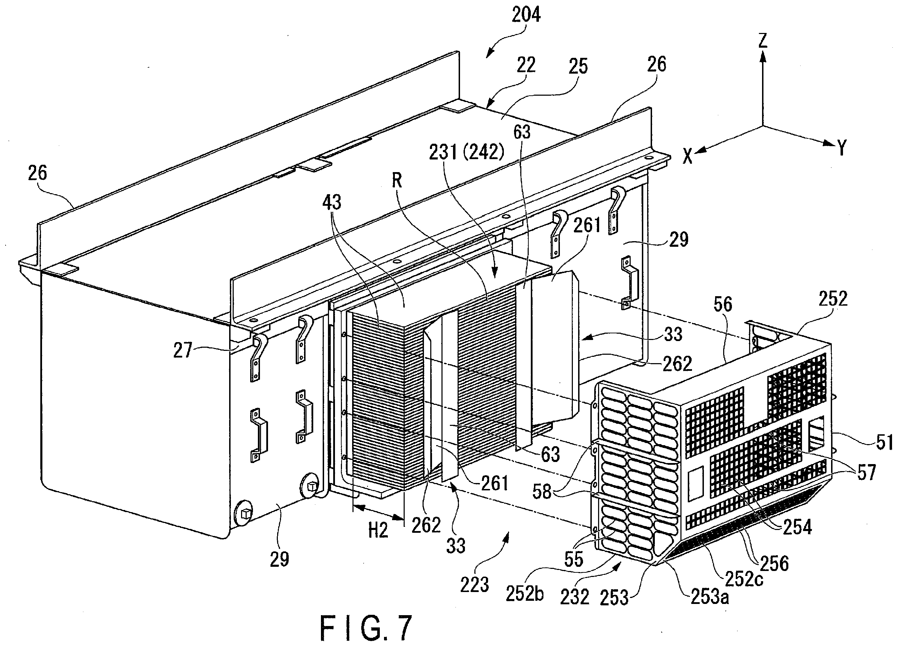

Next, the second embodiment will be described with reference to FIGS. 7 to 9.

FIG. 7 is an exploded perspective view of a power conversion device 204 according to the second embodiment, and corresponds to FIG. 4 described above. Note that the same aspects as those of the first embodiment are denoted by the same reference numerals and descriptions thereof are omitted.

In the second embodiment, the following basic configuration is the same as that of the first embodiment described above. That is, the power conversion device 204 is provided under a floor of a vehicle body 2 of a railway vehicle 1. The power conversion device 204 includes a semiconductor element 21, a housing 22 that accommodates the semiconductor element 21, and a cooler 223 that cools the semiconductor element 21. The cooler 223 includes a heat sink 231, a cover 232, and a diffuser 233.

Here, the difference between the first embodiment and the second embodiment is that the size of the cooler 23 of the first embodiment and the size of the cooler 223 of the second embodiment are different.

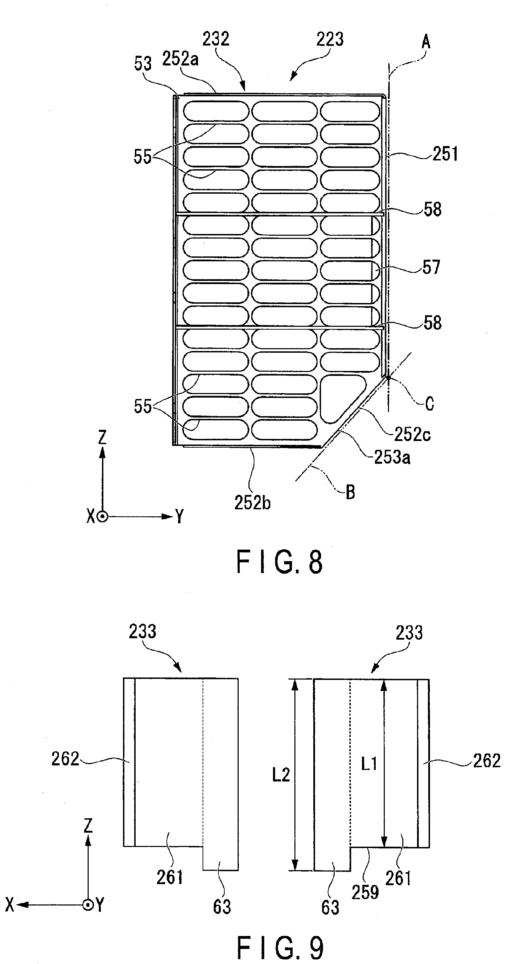

FIG. 8 is a plan view of the cover 232 of the cooler 223 in the second embodiment as viewed from the X direction, and corresponds to FIG. 5 in the first embodiment described above.

As shown in the figure, the cover 232 is formed to have a maximum size that falls within the outfit limit, that is, to be as large as possible along the outfit limit lines A and B. Thus, the cover 232 has a top wall 251 disposed on the outer side in the Y direction with respect to an air receiver 42, a pair of lateral side walls 252a and 252b extending inward in the Y direction from portions of the outer peripheral edge of the top wall 251 located on both sides in the Z direction, and a pair of vertical side walls 253 extending inward in the Y direction from portions of the outer peripheral edge of the top wall 51 located on both sides in the X direction.

The top wall 51 is located close to and along the outfit limit line A. The top wall 51 includes communication holes 54, and is provided with stays 57.

In addition, of the pair of lateral side walls 252a and 252b, the lateral side wall 252b on the -Z side is positioned in the -Z direction from the intersection point C between the outfit limit line A and the outfit limit line B. A part of the lateral side wall 252b outside in the Y direction is an inclined surface 252c inclined with respect to the Y direction and along the outfitting limit line B. A plurality of communication holes 256 (see FIG. 7) for communication between the inside and outside of the lateral side wall 252b and the inclined surface 252c are formed in the lateral side wall 252b and the inclined surface 252c.

An inclined side 253a is formed on the outer side in the -Z direction and the Y direction of the pair of vertical side wall portions 253 so as to correspond to the inclined surface 252c of the lateral side wall 252b. Further, the communication holes 55 are formed and the stays 57 are provided in the vertical side wall 253.

The air receiver 242 (heat sink 231, see FIG. 7) is formed larger than the air receiver 42 of the first embodiment so as to correspond to the shape of the cover 232.

That is, a protrusion height H2 of the air receiver 242 to the outside in the Y direction is set higher than a protrusion height H1 (see Fig. 3) of the air receiver 42 of the first embodiment to the outside in the Y direction.

FIG. 9 is a plan view of the diffuser 233 seen from the outside in the Y direction.

As shown in the figure, since the air receiver 242 is upsized in accordance with the cover 232, the diffuser 233 is also modified so as not to interfere with the cover 232. That is, among an air guide 261, a flange 262, and an airflow straightener 63 that constitute the diffuser 233, the length L1 in the Z direction of the air guide 261 and the flange 262 that are arranged so as to be separated from the outer surface of the air receiver 242 in the Y direction is set shorter than the length L 2 in the Z direction of the airflow straightener 63 that is arranged close to the outer surface of the air receiver 242 in the Y direction. As a result, the air guide 261 and the flange 262 have a shape in which a cutout 259 is formed at the end in the -Z direction. As a result, it is possible to prevent the air guide 261 and the flange 262 from interfering with the inclined surface 252c of the cover 232.

As such, in the second embodiment, the cooler 223 is formed to the maximum size within the outfit limit. Therefore, in addition to the same effects as those of the first embodiment, the cooling performance of the air receiver 242 can be further improved.

In the embodiments described above, the diffuser 33, 233 is arranged on both sides of the air receiver 42, 242 in the X direction. However, the present invention is not limited to this, and the diffuser 33, 233 may be disposed at least on the rear side of the air receiver 42, 242 in the assumed travel direction.

Further, in the embodiments described above, the cooler 23, 223 is provided with the cover 32, 232, and the diffusers 33, 233 are connected to the vertical side walls 53, 253 of the cover 32, 232. However, the present invention is not limited to this, and it is also possible to omit the cover 32, 232 and connect the diffusers 33, 233 directly under the floor of the air receiver 42, 242 and the vehicle body 2.

Further, in the above embodiments, the case where the power conversion device 4, 204 is mounted on the railway vehicle 1 has been described. However, the present invention is not limited to this, and the power conversion device 4, 204 can be mounted on various vehicles.

According to at least one embodiment described above, since the diffusers 33, 233 each include the air guide 61, 261, the flange 62, 262, and the airflow straightener 63, the traveling wind flowing through the cover 32, 232 can be drawn toward the low-pressure region Q formed behind the rear diffuser 33, 233. Therefore, the flow rate of the traveling wind passing through the rear diffuser 33, 233 can be increased, and the traveling wind to escape from the air receiver 42, 242 can be pulled back into the ventilation path R.

Further, since the diffusers 33, 233 are each provided with the airflow straightener 63, it is possible to suppress the travelling wind from being drawn into the low-pressure region S generated between the front diffuser 33, 233 and the rear diffuser 33, 233. That is, even when the differential pressure between the low-pressure region Q of the rear diffuser 33, 233 and the periphery of the low-pressure region Q is small, it is possible to suppress as much as possible the outflow amount of the traveling wind that attempts to escape from the inside of the ventilation path R to the outside in the Y direction. As a result, the effect of increasing the flow rate of the traveling wind in the air receiver 42, 242 can be exhibited over the entire speed range of the railway vehicle 1. Therefore, the cooling performance of the air receiver 42, 242 can be improved.

While some embodiments of the present invention have been described, these embodiments are presented as examples and are not intended to limit the scope of the invention. These embodiments can be implemented in other various forms, and various omissions, replacements, and modifications can be made without departing from the scope of the invention as defined in the appended claims. These embodiments and modifications thereof are included in the invention described in the claims and the equivalents thereof as well as included in the scope of the invention.

## Claims

1. A power conversion device (4) comprising:
a semiconductor element (21) configured to output power for driving a vehicle;
an air receiver (42) connected to the semiconductor element (21);
an air guide (61), wherein when an assumed travel direction of the vehicle is a first direction (X), a direction of gravity (Z) is a second direction, and a direction perpendicular to the first and second direction is a third direction (Y), the air guide (61) is disposed to face the air receiver (42) in the third direction (Y), wherein, among both ends of the air guide (61) in the first direction, a first end is near a center of the air receiver, and a second end is opposite from the first end; and
a flange (62) extending from the second end of the air guide and away from the air receiver (42),
wherein a distance between the second end of the air guide (61) and the air receiver (42) in the second direction (Z) is equal to or greater than a distance between the first end of the air guide (61) and the air receiver (42) in the second direction (Z)
**characterized by**
an airflow straightener (63) extending from the first end of the air guide (61) along the first direction (X) and away from the second end.

2. The power conversion device (4) according to claim 1, wherein a distance between the air guide (61) and the air receiver (42) in the second direction (Z) gradually increases from the first end to the second end.

3. The power conversion device according to claim 1 or claim 2, wherein the air guide (61) and the flange (62) are disposed at a position where the first ends of the air guide (61) are separated in the first direction (X) on both sides of the air receiver (42) in the first direction (X).

4. The power conversion device (4) according to any one of claims 1-3, further comprising a cover (32) for covering the air receiver (42), the air guide (61) , the airflow straightener (63) and the flange (62), the cover (32) including a top wall (51) facing the air receiver in the third direction (Y), a pair of vertical side walls (53) extending from respective sides of the top wall in the first direction (X) towards the third direction (Z) and opposed to each other in the first direction (X), and a pair of lateral side walls (52) extending from respective sides of the top wall (51) in the second direction (Z) towards the third direction (Y) and opposed to each other in the second direction (Z),
wherein the top wall (51), the pair of vertical side walls (53) and the pair of lateral side walls (52) are formed with communication holes (54),
a first reinforcing portion (58) for reinforcing the vertical side wall (53) and extending along the third direction (Y) is provided on the vertical side wall (53), and
a second reinforcing section (57) for reinforcing the top wall (51) and extending along the first direction (X) is provided on the top wall portion.

5. The power conversion device (4) according to claim 4, wherein lower one of the pair of lateral side walls (52) in a direction of gravity (Z) is inclined with respect to the third direction (Y) and along an outfit limit, and the communication holes (54) are provided in the pair of lateral side walls (52).

6. The power conversion device (4) according to any one of claims 1-5, wherein a length in the second direction of air guide (61) and the flange (62) is shorter than a length in the second direction of the airflow straightener (63) so as to correspond to an outfit limit.

7. A railway vehicle (1) comprising a power conversion device (4) according to any one of claims 1-6.

## Patentansprüche

1. Leistungsumwandlungsvorrichtung (4), die Folgendes umfasst:
ein Halbleiterelement (21), das dazu ausgestaltet ist, Leistung zum Antreiben eines Fahrzeugs abzugeben;
einen Luftbehälter (42), der mit dem Halbleiterelement (21) verbunden ist;
eine Luftführung (61), wobei, wenn eine angenommene Bewegungsrichtung des Fahrzeugs eine erste Richtung (X) ist, eine Schwerkraftrichtung (Z) eine zweite Richtung ist und eine Richtung senkrecht zur ersten und zweiten Richtung eine dritte Richtung (Y) ist, die Luftführung (61) angeordnet ist, um dem Luftbehälter (42) in der dritten Richtung (Y) zugewandt zu sein, wobei unter beiden Enden der Luftführung (61) in der ersten Richtung ein erstes Ende sich in der Nähe einer Mitte des Luftbehälters befindet und ein zweites Ende dem ersten Ende entgegengesetzt ist; und
einen Flansch (62), der sich von dem zweiten Ende der Luftführung und von dem Luftbehälter (42) weg erstreckt,
wobei ein Abstand zwischen dem zweiten Ende der Luftführung (61) und dem Luftbehälter (42) in der zweiten Richtung (Z) gleich oder
größer als ein Abstand zwischen dem ersten Ende der Luftführung (61) und dem Luftbehälter (42) in der zweiten Richtung (Z) ist,
**gekennzeichnet durch**
einen Luftströmungsgleichrichter (63), der sich von dem ersten Ende der Luftführung (61) entlang der ersten Richtung (X) und von dem zweiten Ende weg erstreckt.

2. Leistungsumwandlungsvorrichtung (4) nach Anspruch 1, wobei ein Abstand zwischen der Luftführung (61) und dem Luftbehälter (42) in der zweiten Richtung (Z) allmählich vom ersten Ende zum zweiten Ende zunimmt.

3. Leistungsumwandlungsvorrichtung nach Anspruch 1 oder Anspruch 2, wobei die Luftführung (61) und der Flansch (62) an einer Position angeordnet sind, wo die ersten Enden der Luftführung (61) in der ersten Richtung (X) auf beiden Seiten des Luftbehälters (42) in der ersten Richtung (X) getrennt sind.

4. Leistungsumwandlungsvorrichtung (4) nach einem der Ansprüche 1 bis 3, die ferner eine Abdeckung (32) zum Abdecken des Luftbehälters (42), der Luftführung (61), des Luftströmungsgleichrichters (63) und des Flansches (62) umfasst, wobei die Abdeckung (32) eine obere Wand (51), die dem Luftbehälter in der dritten Richtung (Y) zugewandt ist, ein Paar vertikale Seitenwände (53), die sich von entsprechenden Seiten der oberen Wand in der ersten Richtung (X) hin zu der dritten Richtung (Z) erstrecken und einander in der ersten Richtung (X) entgegengesetzt sind, und ein Paar laterale Seitenwände (52) umfasst, die sich von entsprechenden Seiten der oberen Wand (51) in der zweiten Richtung (Z) hin zur dritten Richtung (Y) und einander in der zweiten Richtung (Z) entgegengesetzt erstrecken,
wobei die obere Wand (51), das Paar vertikaler Seitenwände (53) und das Paar lateraler Seitenwände (52) mit Verbindungslöchern (54) gebildet sind,
ein erster Verstärkungsabschnitt (58) zum Verstärken der vertikalen Seitenwand (53) und der sich entlang der dritten Richtung (Y) erstreckt, auf der vertikalen Seitenwand (53) bereitgestellt ist, und
ein zweiter Verstärkungsabschnitt (57) zum Verstärken der oberen Wand (51) und der sich entlang der ersten Richtung (X) erstreckt, auf dem oberen Wandabschnitt bereitgestellt ist.

5. Leistungsumwandlungsvorrichtung (4) nach Anspruch 4, wobei die niedrigere von dem Paar lateraler Seitenwände (52) in einer Schwerkraftrichtung (Z) in Bezug auf die dritte Richtung (Y) und entlang einer Ausrüstungsgrenze geneigt ist und die Verbindungslöcher (54) in dem Paar lateraler Seitenwände (52) bereitgestellt sind.

6. Leistungsumwandlungsvorrichtung (4) nach einem der Ansprüche 1 bis 5, wobei eine Länge in der zweiten Richtung der Luftführung (61) und des Flansches (62) in der zweiten Richtung kürzer als eine Länge des Luftströmungsgleichrichters (63) in der zweiten Richtung ist, um einer Ausrüstungsgrenze zu entsprechen.

7. Schienenfahrzeug (1), das eine Leistungsumwandlungsvorrichtung (4) nach einem der Ansprüche 1 bis 6 umfasst.

## Revendications

1. Dispositif de conversion de puissance (4) comprenant :
un élément semi-conducteur (21) configuré pour délivrer une puissance pour entraîner un véhicule ;
un récepteur d'air (42) relié à l'élément semi-conducteur (21) ;
un guide d'air (61), dans lequel, lorsqu'une direction de déplacement supposée du véhicule est une première direction (X), une direction de la gravité (Z) est une deuxième direction, et une direction perpendiculaire aux première et deuxième directions est une troisième direction (Y), le guide d'air (61) est disposé pour faire face au récepteur d'air (42) dans la troisième direction (Y), dans lequel, parmi les deux extrémités du guide d'air (61) dans la première direction, une première extrémité est proche d'un centre du récepteur d'air, et une deuxième extrémité est à l'opposé de la première extrémité ; et
une bride (62) s'étendant depuis la deuxième extrémité du guide d'air et à l'écart du récepteur d'air (42),
dans lequel une distance entre la deuxième extrémité du guide d'air (61) et le récepteur d'air (42) dans la deuxième direction (Z) est supérieure ou égale à une distance entre la première extrémité du guide d'air (61) et le récepteur d'air (42) dans la deuxième direction (Z),
**caractérisé par**
un redresseur d'écoulement d'air (63) s'étendant depuis la première extrémité du guide d'air (61) dans la première direction (X) et à l'écart de la deuxième extrémité.

2. Dispositif de conversion de puissance (4) selon la revendication 1, dans lequel une distance entre le guide d'air (61) et le récepteur d'air (42) dans la deuxième direction (Z) augmente progressivement de la première extrémité à la deuxième extrémité.

3. Dispositif de conversion de puissance selon la revendication 1 ou 2, dans lequel le guide d'air (61) et la bride (62) sont disposés à une position à laquelle les premières extrémités du guide d'air (61) sont séparées dans la première direction (X) sur les deux côtés du récepteur d'air (42) dans la première direction (X).

4. Dispositif de conversion de puissance (4) selon l'une quelconque des revendications 1 à 3, comprenant en outre un couvercle (32) pour recouvrir le récepteur d'air (42), le guide d'air (61), le redresseur d'écoulement d'air (63) et la bride (62), le couvercle (32) incluant une paroi supérieure (51) faisant face au récepteur d'air dans la troisième direction (Y), une paire de parois de côté vertical (53) s'étendant depuis des côtés respectifs de la paroi supérieure dans la première direction (X) vers la troisième direction (Z) et à l'opposé l'une de l'autre dans la première direction (X), et une paire de parois de côté latéral (52) s'étendant depuis des côtés respectifs de la paroi supérieure (51) dans la deuxième direction (Z) vers la troisième direction (Y) et à l'opposé l'une de l'autre dans la deuxième direction (Z),
dans lequel la paroi latérale (51), la paire de parois de côté vertical (53) et la paire de parois de côté latéral (52) sont formées avec des trous de communication (54),
une première partie de renforcement (58) pour renforcer la paroi de côté vertical (53) et s'étendant dans la troisième direction (Y) est prévue sur la paroi de côté vertical (53), et
une deuxième partie de renforcement (57) pour renforcer la paroi supérieure (51) et s'étendant dans la première direction (X) est prévue sur la partie de paroi supérieure.

5. Dispositif de conversion de puissance (4) selon la revendication 4, dans lequel l'une inférieure parmi la paire de parois de côté latéral (52) dans une direction de la gravité (Z) est inclinée par rapport à la troisième direction (Y) et le long d'une limite de l'équipement, et les trous de communication (54) sont prévus dans la paire de parois de côté latéral (52).

6. Dispositif de conversion de puissance (4) selon l'une quelconque des revendications 1 à 5, dans lequel une longueur dans la deuxième direction du guide d'air (61) et de la bride (62) est inférieure à une longueur dans la deuxième direction du redresseur d'écoulement d'air (63) de manière à correspondre à une limite de l'équipement.

7. Véhicule ferroviaire (1) comprenant un dispositif de conversion de puissance (4) selon l'une quelconque des revendications 1 à 6.
